# EUROPEAN PATENT SPECIFICATION

(11) **EP 0 772 905 B1**
(45) Date of publication and mention of the grant of the patent: **01.03.2000**
(21) Application number: 95918083.7
(22) Date of filing: 10.05.1995
(51) Int. Cl.: H03D 3/00

(54) **A DIRECT CONVERSION RECEIVER**
DIREKTMISCHEMPFÄNGER
RECEPTEUR A CONVERSION DIRECTE

(43) Date of publication of application: 14.05.1997
(73) Proprietor: ROKE MANOR RESEARCH LIMITED, Romsey, Hampshire, SO51 0ZN (GB)
(72) Inventor: SMITH, Christopher, Nigel, Romsey, Hampshire SO51 7RJ (GB)
(74) Representative: Mackett, Margaret Dawn
(86) International application number: PCT/GB95/01058
(87) International publication number: WO 96/36104

(56) References cited:
- EP-A- 0 270 160
- US-A- 4 985 684

## Description

The present invention relates to a direct conversion receiver for use in radio systems.

It is known to use direct conversion in radio receivers which avoid the use of bulky and expensive bandpass IF filters. Also, the use of RF filters is considerably simplified and a complete receiver may be integrated onto a single chip.

In practice, one of the main obstacles to the successful implementation of direct conversion, particularly in the digital communications environment, is a requirement for automatic gain control (AGC). In a direct conversion receiver, AGC must be derived from baseband, which often makes it too slow for use with the bursted signals commonly used in modern digital systems.

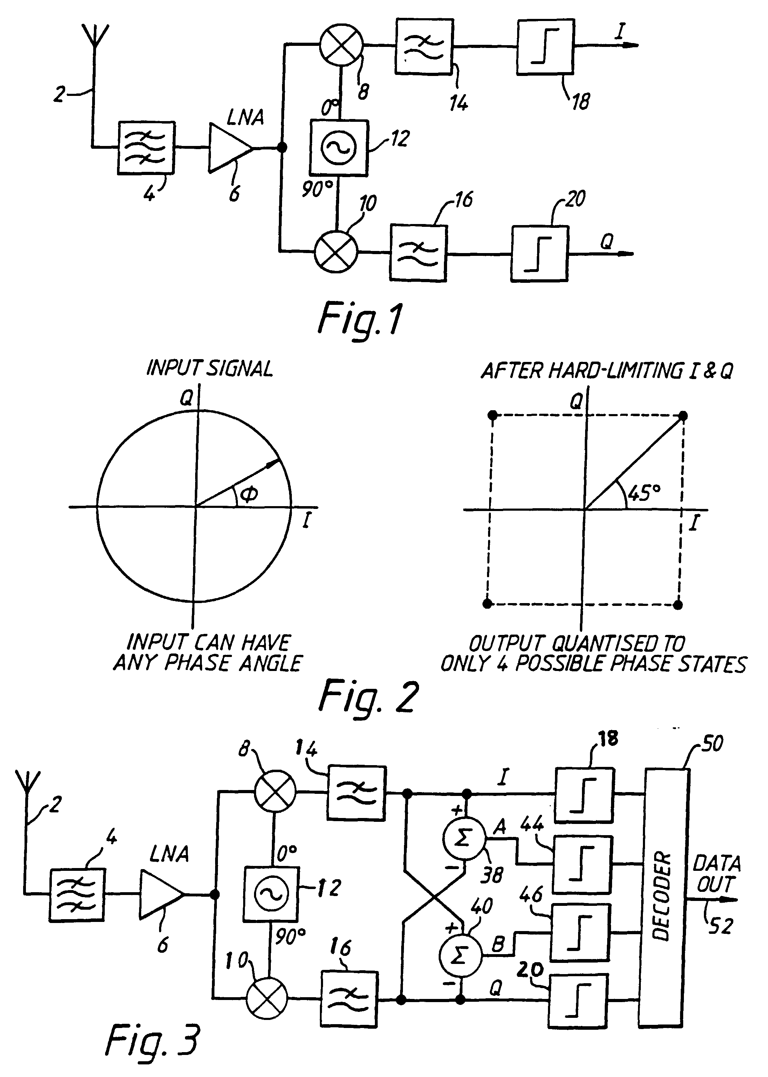

Referring to Figures 1 and 2, Figure 1 shows an arrangement which is often used in low data rate paging receivers and includes an antenna 2 connected to an input of a blocking filter 4, the output of which is connected to an input of an amplifier 6. The output of the amplifier is applied to an input of a mixer 8, 10 respectively, which receive at a second input thereof, an output from an oscillator 12. The mixer 8 receives a signal which is at 0° phase from the oscillator 12, and the mixer 10 receives a signal which is at 90° phase from the oscillator 12. The outputs of the mixers 8 and 10 are applied respectively to an input of a low pass filter 14, 16, the output of which is applied to limiters 18, 20 respectively. The output from the limiter 18 is an in-phase signal I, and the output from the limiter 20 is a quadrature phase signal Q. The circuit thus described does not require any AGC.

If the inputs of the receiver is a frequency shift keyed (FSK) signal, it may be represented vectorially as shown in Figure 2. The left hand diagram of Figure 2 shows that the input can have any phase angle, whereas the output, after hard limiting, the I and Q signals are quantised to any four possible phase states, as shown in the right hand diagram of Figure 2.

In order to demodulate the FSK modulation, it is necessary to establish the direction of rotation of the vector. This is straight forward in paging systems where the modulation index is high, since the vector will rotate several cycles for each data bit. The limited I and Q output signals then become a burst of square waves at 90° to each other, either leading or lagging, depending upon the direction of rotation. By comparing the limited I and Q signals in a phase sensitive detector (e.g. a D-Type flip-flop), the polarity of the phase difference, and hence modulation can be recovered.

However, in more spectrally efficient, low modulation index schemes such as Gaussian frequency shift keying (GFSK), the vector can rotate as little as 50° per data bit. This means that the vector can remain entirely within one quadrant, so there is no change at the limiter outputs. In this case the data is not recoverable.

An aim of the present invention is to provide a direct conversion receiver for use with phase modulation signals, which does not require AGC.

EP-A-0 270 160 discloses a process for the acquisition of carrier synchronisation in coherent demodulators in which an added frequency characteristic is added to the phase-lock loop of the demodulator. Quadrature signals are added and subtracted to form four signals, which are then passed to processing means where the inphase and quadrature signals are sampled at one frequency, f_{c}, and the other two signals are sampled at twice that frequency, 2f_{c}.

According to the present invention, there is provided a direct conversion receiver for converting an input RF signal, the receiver comprising:- antenna means for receiving an input signal transmitted across a radio medium; first circuit means for generating an in-phase and a quadrature phase signals from the received input signal; second circuit means for receiving the in-phase and quadrature phase signals and generating a plurality of additional phase signals which have phase states intermediate to the phase states of the inphase and quadrature phase signals; generating means for generating output inphase, quadrature and additional phase signals in the form of a burst of hard-limited signals; and decoding means for receiving the bursts of hard-limited signals and for generating data signals corresponding to the received input signal; characterised in that the decoding means comprises logic circuit means for providing an output signal representing one of at least eight possible instantaneous phase states of the received input signal when at least two additional phase signals are used, and means for subtracting a previous phase state from the present phase state of the received input signal to generate a series of pulses dependent on the sign of the phase shift.

In one embodiment of the present invention, the second circuit means may include first and second summator circuits, the first of which is arranged to sum the in-phase and quadrature phase signals, the second of which is arranged to subtract the in-phase and quadrature phase signals thereby generating phase signals having phases which are intermediate those of the in-phase and quadrature phase signals.

In a further embodiment, the second circuit means may include a ratiometric combiner arranged to generate six additional phase signals which have phases which are intermediate those of the in-phase and quadrature phase signals.

Various embodiments of the present invention will now be described with reference to the accompanying drawings, wherein,
FIGURE 1 shows a direct conversion receiver,
FIGURE 2 shows the phase angle of an incoming signal and four possible phase states,
FIGURE 3 shows a direct conversion receiver using four limiters,
FIGURE 4 shows the vector signal representation in a four phase receiver,
FIGURE 5 shows a block diagram of an FSK decoder,
FIGURE 6 shows a block diagram of a direct conversion receiver using 'n' limiters, and,
FIGURE 7 shows a block diagram of Π/4-DQPSK (differential quadrature phase shift keyed) decoder.

Referring to Figure 3, there is shown a block diagram of a direct conversion receiver using four limiters. The receiver as shown overcomes the drawback mentioned with respect to the prior art by effectively introducing additional phase signals, intermediate to the phases of the in-phase I and quadrature phase Q signals. The simplest realisation of this is to add two additional phase signals at 45° and 135°, by taking the sum and difference of the in-phase I and quadrature phase Q signals, and hard limiting the two new signals designated A and B, as shown in the drawing. The receiver comprises an antenna 2 connected to a blocking filter 4, the output of which is applied to an amplifier 6. The output of the amplifier 6 is applied to a first input of a mixer circuit 8, 10 respectively. The mixer circuit 8 receives an in-phase signal I from an oscillator 12, and the mixer circuit 10 receives a quadrature phase signal Q from an oscillator 12. An output from each mixer circuit 8, 10 is applied to an input of a low pass filter 14, 16, respectively. The output of the filter 14 represents the in-phase signal I and is applied to an input of a limiter 18, an input of a summator circuit 38, and to an input of a summator circuit 40. Similarly the output of the filter 16 which represents the quadrature phase Q signal, is applied to an input of a limiter 20, a further input of summator 40 and to a futher input of the summator 38. The summator 38 generates an output signal A which is the summation of the two input signals, and the summator 40 generates an output signal B which is the difference of the two input signals. The output of the summator 38 is applied to a limiter 44, and the output of the summator 40 is applied to an input of a limiter 46. Each of the limiters 18, 20, 44, 46 generates and output signal which is applied to a decoder 50 from which an output data signal is generated on an output line 52.

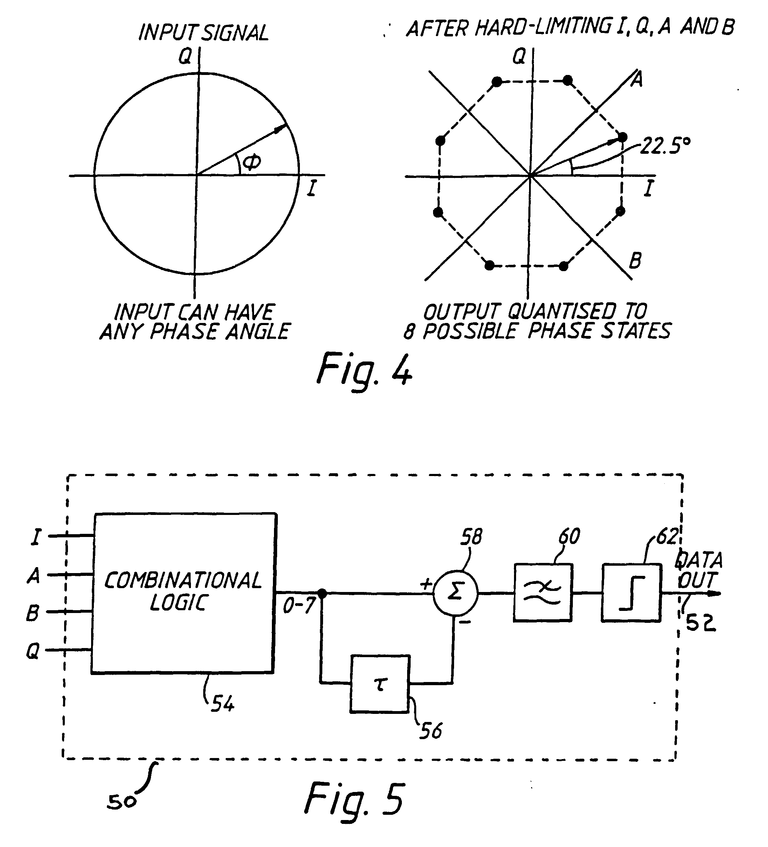

The vector diagram in relation to Figure 3 is shown in Figure 4. With four phase signals there are now eight sectors, and the hard limited signals effectively represent the signals quantised to eight possible phase states, separated by 45°. When the input signal is a GFSK modulated signal, the vector will now always cross at least one axis, so the direction of rotation can be established and the data recovered.

With reference to Figure 4, the left hand diagram shows that the input signal can have any phase angle, and the right hand diagram shows that after hard limited the output is quantised to eight possible phase states.

The decoding of the data may be achieved digitally from the binary signals at the outputs of the limiters 18, 20, 44, 46 in Figure 3, and the decoding is shown with reference to Figure 5. Figure 5 shows an FSK decoder comprising combinational logic circuit 54 which receives the I, A, B and Q inputs from the limiters 18, 20, 44, 46 in Figure 3. The output of the combinational logic circuit 54 is connected to an input of a delay circuit 56 and to the input of a summator circuit 58. The output of the delay circuit 56 is connected to a further input of the summator circuit 58. The output of the summator circuit 58 is connected to an input of an averaging circuit 60, the output of which is applied to a hard limiter 62 from which data is output on an output line 52.

The simple combinational logic may be used to give a binary sector output from 0 to 7 representing the phase sector in which the signal instantaneously resides. By subtracting the previous sector value from the present sector value (modulo-8 arithmetic), a series of pulses is obtained which are either positive or negative, depending upon the direction of rotation. Effectively, a sampled frequency discriminator is formed. To avoid aliassing, the delay element should be less than half a bit period. The pulse train is then averaged in the circuit 60 and limited by the circuit 62 to extract the data.

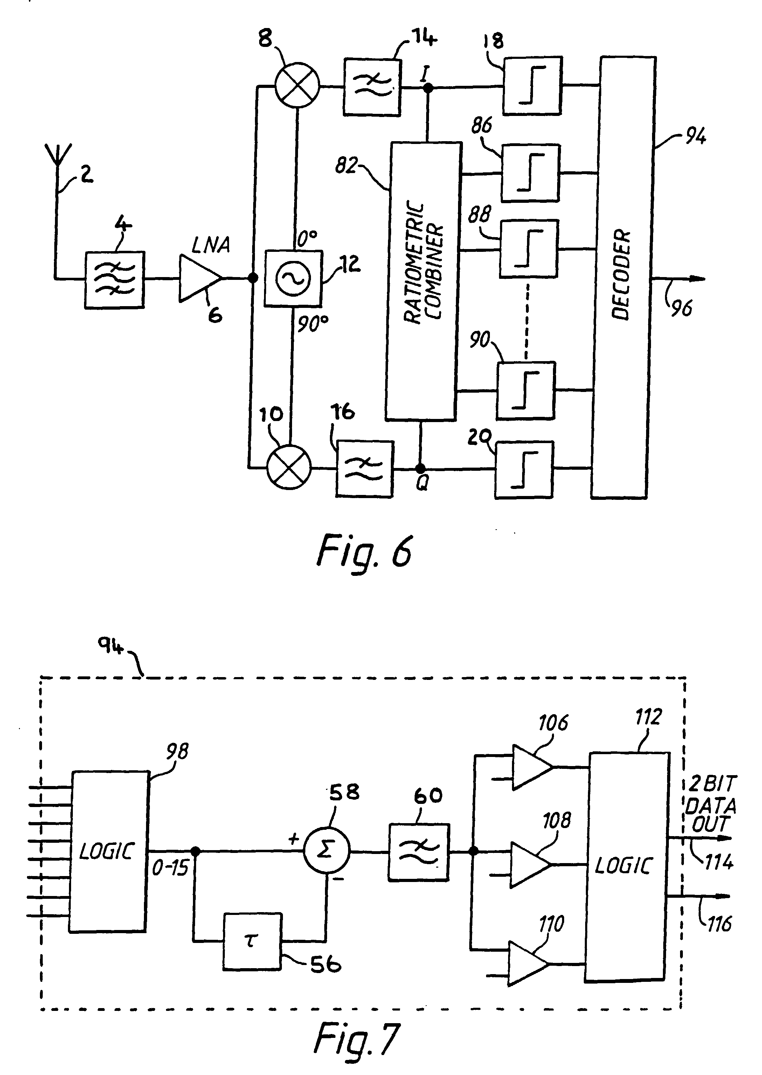

In modulation schemes where the phase excursion per bit is even less (such as π/4-DQPSK or GFSK with a very low BT factor where B is the bandwidth of the modulation filter and T is the bit period), the technique can be expanded by introducing more additional phase signals, hence improving the phase resolution. This concept is shown in Figure 6.

Referring to Figure 6, a further embodiment of the present invention will now be described, and shows a direct conversion receiver using 'n' limiters.

The receiver comprises antenna 2 which feeds an RF filter 4, the output of which is connected to an input of an amplifier 6. The output of the amplifier 6 is applied to the input of a mixer circuit 8 and to an input of a mixer circuit 10. The second inputs of the mixer circuits 8, 10 receive and output from an oscillator 12 in the form of an in-phase signal applied to the mixer circuit 8, and a quadrature phase signal applied to the mixer circuit 10. An output of the mixer circuit 8 is applied to a low pass filter 14, and similarly the output of the mixer circuit 10 is applied to a low pass filter 16. The outputs of the filters 14, 16 are each applied to ratiometric combiner 82 respectively, and to an input of a limiter 18 and a limiter 20, respectively. The ratiometric combiner 82 generates a number of output signals, each of which is applied to an input of a limiter 86-90 respectively. An output from each limiter is applied to an input to a decoder circuit 94 which is arranged to generate an output signal on an output line 96.

In π/4 DQPSK modulation, the phase excursion per symbol is ± 45° or ± 135° depending on the bit pair combination (00, 01, 10 or 11). In the receiver the arrangement as shown in Figure 6, a minimum of eight phase signals (and eight limiters) would therefore be required giving sixteen sectors and 22.5° phase resolution. The decoding would also change slightly from the FSK version, since three decision thresholds would be needed to detect the magnitude as well as the polarity of the phase shift. The decoder circuit 94 is shown in Figure 7.

Referring to Figure 7, a decoder circuit comprises a logic circuit 98 which receives the input signals from the limiter circuits 18, 20, 86, 88, 90 (Figure 6). An output from the logic circuit 98 is applied to the input of a summator circuit 58 and to input of a delay circuit 56. An output from the delay circuit 56 is connected to a further input of the summator circuit 58. An output from the summator circuit 58 is connected to an input of an averaging circuit 60, the output of which is applied to three threshold devices 106, 108, 110, which are arranged to compare the output of the averaging circuit 60 with a threshold signal applied to a second input thereof. The output of each threshold circuit 106-110 is applied to an input of a logic circuit 112, respectively, which is arranged to generate an output data bit on an output line 114, and an output line 116.

It will be appreciated by those skilled in the art that variations and modifications are possible within the scope of the following claims. The receiver is primarily aimed at phase of frequency modulation schemes. However, it will be appreciated that in systems where the envelope variation must be preserved (e.g. for equalisation), the signal envelope could be obtained from the limiter received signal strength indicator (RSSI) outputs. As this would be log-compressed envelope, and anti-log function would be needed to restore the linear amplitude variation.

## Claims

1. A direct conversion receiver for converting an input RF signal, the receiver comprising:-
antenna means (2) for receiving an input signal transmitted across a radio medium;
first circuit means (4, 6, 8, 10, 12, 14, 16) for generating an in-phase (I) and a quadrature (Q) phase signals from the received input signal;
second circuit means (38, 40; 82) for receiving the in-phase (I) and quadrature (Q) phase signals and generating a plurality of additional phase signals (A, B) which have phase states intermediate to the phase states of the inphase (I) and quadrature (Q) phase signals;
generating means (18, 44, 46, 20; 86, 88, 90) for generating output inphase, quadrature and additional (I, Q, A, B) phase signals in the form of a burst of hard-limited signals; and
decoding means (50, 54, 56, 58, 60, 62; 94, 98, 106, 108, 110, 112) for receiving the bursts of hard-limited signals and for generating data signals corresponding to the received input signal;
characterised in that the decoding means (50, 54, 56, 58, 60, 62; 94, 98, 106, 108, 110, 112) comprises logic circuit means (54, 98) for providing an output signal (52; 96, 114, 116) representing one of at least eight possible instantaneous phase states of the received input signal when at least two additional phase signals are used, and means (56, 58) for subtracting a previous phase state from the present phase state of the received input signal to generate a series of pulses dependent on the sign of the phase shift.

2. A direct conversion receiver according to claim 1, wherein the series of pulses are applied to an averaging circuit (60), the output from the averaging circuit (60) being applied to a limiting circuit (62) arranged to extract data therefrom.

3. A direct conversion receiver according to claim 2, wherein the second circuit means (38, 40) comprises first and second summator circuits which are arranged to sum the inphase (I) and quadrature (Q) phase signals and to subtract the inphase (I) and quadrature (Q) phase signals respectively in any ratio to generate two additional phase signals (A, B).

4. A direct conversion receiver according to any one of claims 1 to 3, wherein the decoding means (50) comprises a frequency shift keyed (FSK) decoder.

5. A direct conversion receiver according to claim 1, wherein the series of pulses are applied to an averaging circuit (60), the output from the averaging circuit (60) being applied to each of three decision circuits (106, 108, 110) which are arranged to detect the magnitude and polarity of phase shift of the received input signal, the output from each decision circuit (106, 108, 110) forming inputs to an output logic circuit (112) which generates data output signals (114, 116).

6. A direct conversion receiver according to claim 5, wherein the second circuit means (82) comprises a ratiometric combiner arranged to generate a plurality of phase signals whose phase states are intermediate the phase states of the inphase (I) and quadrature (Q) phase signals.

7. A direct conversion receiver according to claim 6, wherein the decoding means (94) is arranged to generate an output signal representing one of sixteen possible instantaneous phase states of the received signal when six additional phase signals are used.

8. A direct conversion receiver according to any one of claims 5 to 7, wherein the decoding means (94) comprises a π/4-differential quadrature phase key shifted (DQPSK) decoder.

## Patentansprüche

1. Direktumsetzungsempfänger zum Umsetzen eines Eingangs-HF-Signals, wobei der Empfänger enthält:
Antennenmittel (2) zum Empfangen eines über ein Funkmedium gesendeten Eingangssignals;
erste Schaltungsmittel (4, 6, 8, 10, 12, 14, 16) zum Erzeugen eines phasengleichen (I) und eines um 90° phasenverschobenen (Q) Phasensignals aus dem empfangenen Eingangssignal;
zweite Schaltungsmittel (38, 40; 82) zum Empfangen der phasengleichen (I) und um 90° phasenverschobenen (Q) Phasensignale und zum Erzeugen mehrerer zusätzlicher Phasensignale (A, B), deren Phasenzustände zwischen den Phasenzuständen der phasengleichen (I) und der um 90° phasenverschobenen (Q) Phasensignale liegen;
Erzeugungsmittel (18, 44, 46, 20; 86, 88, 90) zum Erzeugen von phasengleichen, um 90° phasenverschobenen und zusätzlichen Phasensignalen (I, Q, A, B) in Form eines Bündels hart begrenzter Signale; und
Decodierungsmittel (50, 54, 56, 58, 60, 62; 94, 98, 106, 108, 110, 112) zum Empfangen der Bündel hart begrenzter Signale und zum Erzeugen von Datensignalen, die dem empfangenen Eingangssignal entsprechen;
dadurch gekennzeichnet, daß die Decodierungsmittel (50, 54, 56, 58, 60, 62; 94, 98, 106, 108, 110, 112) Logikschaltungsmittel (54, 98), die ein Ausgangssignal (52; 96, 114, 116) erzeugen, das einen von wenigstens acht möglichen momentanen Phasenzuständen des empfangenen Eingangssignals repräsentiert, wenn wenigstens zwei zusätzliche Phasensignale verwendet werden, sowie Mittel (56, 58) enthalten, die einen vorhergehenden Phasenzustand vom momentanen Phasenzustand des empfangenen Eingangssignals subtrahieren, um eine Reihe von vom Vorzeichen der Phasenverschiebung abhängenden Impulsen zu erzeugen.

2. Direktumsetzungsempfänger nach Anspruch 1, wobei die Reihe von Impulsen in eine Mittelungsschaltung (60) eingegeben wird, wobei das Ausgangssignal von der Mittelungsschaltung (60) in eine Begrenzungsschaltung (62) eingegeben wird, die so beschaffen ist, daß sie hieraus Daten extrahiert.

3. Direktumsetzungsempfänger nach Anspruch 2, wobei die zweiten Schaltungsmittel (38, 40) erste und zweite Summiererschaltungen enthalten, die so beschaffen sind, daß sie in irgendeinem Verhältnis die phasengleichen (I) und die um 90° phasenverschobenen (Q) Phasensignale summieren bzw. in irgendeinem Verhältnis die phasengleichen (I) und um 90° phasenverschobenen (Q) Phasensignale subtrahieren, um zwei zusätzliche Phasensignale (A, B) zu erzeugen.

4. Direktumsetzungsempfänger nach irgendeinem der Ansprüche 1 bis 3, wobei die Decodierungsmittel (50) einen Decodierer mit Frequenzumtastung (FSK-Decodierer) enthalten.

5. Direktumsetzungsempfänger nach Anspruch 1, wobei die Reihe von Impulsen in eine Mittelungsschaltung (60) eingegeben werden, wobei das Ausgangssignal von der Mittelungsschaltung (60) in jede von drei Entscheidungsschaltungen (106, 108, 110) eingegeben wird, die so beschaffen sind, daß sie die Größe und die Polarität der Phasenverschiebung des empfangenen Eingangssignals erfassen, wobei das Ausgangssignal von jeder Entscheidungsschaltung (106, 108, 110) Eingangssignale in eine Ausgangslogikschaltung (112) die Datenausgangssignale (114, 116) erzeugt, bildet.

6. Direktumsetzungsempfänger nach Anspruch 5, wobei die zweiten Schaltungsmittel (82) einen Verhältnismessungskombinierer enthalten, der so beschaffen ist, daß er mehrere Phasensignale erzeugt, deren Phasenzustände zwischen den Phasenzuständen der phasengleichen (I) und der um 90° phasenverschobenen (Q) Phasensignale liegen.

7. Direktumsetzungsempfänger nach Anspruch 6, wobei die Decodierungsmittel (94) so beschaffen sind, daß sie ein Ausgangssignal erzeugen, das einen von sechzehn möglichen momentanen Phasenzuständen des empfangenen Signals repräsentiert, wenn sechs zusätzliche Phasensignale verwendet werden.

8. Direktumsetzungsempfänger nach irgendeinem der Ansprüche 5 bis 7, wobei die Decodierungsmittel (94) einen Decodierer mit π/4-Differenz-Quadratur-Phasenumtastung (DQPSK-Decodierer) enthalten.

## Revendications

1. Récepteur à conversion directe pour convertir un signal d'entrée radiofréquence (RF), le récepteur comportant :
des moyens d'antenne (2) pour recevoir un signal d'entrée émis à travers un support radio,
des premiers moyens de circuit (4, 6, 8, 10, 12, 14, 16) pour générer des signaux de phase en phase (I) et en quadrature (Q) à partir du signal d'entrée reçu,
des seconds moyens de circuit (38, 40 ; 82) pour recevoir les signaux de phase en phase (I) et en quadrature (Q) et générer une pluralité de signaux de phase supplémentaires (A, B) qui ont des états de phase intermédiaires entre les états de phase des signaux de phase en phase (I) et en quadrature (Q),
des moyens de génération (18, 44, 46, 20 ; 86, 88, 90) pour générer des signaux de sortie de phase en phase, en quadrature et supplémentaires (I, Q, A, B) sous la forme d'une salve de signaux écrêtés à niveau constant, et
des moyens de décodage (50, 54, 56, 58, 60, 62 ; 94, 98, 106, 108, 110, 112) pour recevoir les salves de signaux écrêtés à niveau constant et pour générer des signaux de données correspondant au signal d'entrée reçu,
caractérisé en ce que les moyens de décodage (50, 54, 56, 58, 60, 62 ; 94, 98, 106, 108, 110, 112) comportent des moyens de circuit logique (54, 98) pour délivrer un signal de sortie (52 ; 96, 114, 116) représentant un état parmi au moins huit états de phase instantanés possibles du signal d'entrée reçu lorsqu'au moins deux signaux de phase supplémentaires sont utilisés, et des moyens (56, 58) pour soustraire un état de phase antérieur du présent état de phase du signal d'entrée reçu afin de générer une série d'impulsions en fonction du signe du déphasage.

2. Récepteur à conversion directe selon la revendication 1, dans lequel la série d'impulsion est appliquée à un circuit de mise en moyenne (60), la sortie du circuit de mise en moyenne (60) étant appliquée à un circuit de limitation (62) agencé pour extraire des données de celle-ci.

3. Récepteur à conversion directe selon la revendication 2, dans lequel les seconds moyens de circuit (38, 40) comportent des premier et second circuits de sommation qui sont conçus pour effectuer la sommation des signaux de phase en phase (I) et en quadrature (Q) et pour soustraire les signaux de phase en phase (I) et en quadrature (Q) respectivement selon une quelconque proportion pour générer deux signaux de phase supplémentaires (A, B).

4. Récepteur à conversion directe selon l'une quelconque des revendications 1 à 3, dans lequel les moyens de décodage (50) comportent un démodulateur à déplacement de fréquence (FSK) .

5. Récepteur à conversion directe selon la revendication 1, dans lequel la série d'impulsions est appliquée à un circuit de mise en moyenne (60), la sortie du circuit de mise en moyenne (60) étant appliquée à chacun de trois circuits de décision (106, 108, 110) qui sont conçus pour détecter l'amplitude et la polarité du déphasage du signal d'entrée reçu, la sortie de chaque circuit de décision (106, 108, 110) formant des entrées d'un circuit logique de sortie (112) qui génère des signaux de sortie de données (114, 116).

6. Récepteur à conversion directe selon la revendication 5, dans lequel les seconds moyens de circuit (82) comportent un combineur proportionnel agencé pour générer une pluralité de signaux de phase dont les états de phase sont intermédiaires entre les états de phase des signaux de phase en phase (I) et en quadrature (Q).

7. Récepteur à conversion directe selon la revendication 6, dans lequel les moyens de décodage (94) sont agencés pour générer un signal de sortie représentant un des seize états de phase instantanés possibles du signal reçu lorsque six signaux de phase supplémentaires sont utilisés.

8. Récepteur à conversion directe selon l'une quelconque des revendications 5 à 7, dans lequel les moyens de décodage (94) comportent un démodulateur à déplacement de phase à quatre états différentiels de π/4 (DQPSK).
